# DEMANDE DE BREVET EUROPEEN

(11) **EP 0 986 170 A1**
(43) Date de publication de la demande: **15.03.2000**
(21) Numéro de dépôt: 99402233.3
(22) Date de dépôt: 10.09.1999
(51) Int. Cl.: H03F 3/60

(54) **Dispositif d'interface entre un capteur optoélectronique hyperfréquence à large bande et une charge**

(30) Priorité: 11.09.1998 FR 9811364
(71) Demandeur: THOMSON CSF DETEXIS, 92210 Saint-Cloud (FR)
(72) Inventeur: Auric, Claude, 78117 Chateaufort (FR); Dueme, Philippe, 91400 Orsay (FR)
(74) Mandataire: Nicolle, Olivier

(57) **Abrégé**

Le dispositif d'interface est disposé entre un capteur optoélectronique (PHD) et une charge (R50) dont l'impédance est inférieure à celle du capteur. Le dispositif d'interface comprend un étage d'adaptation d'impédance, comportant un amplificateur distribué large bande en fréquences (ADL), dont l'entrée (E) est directement reliée à une borne (BA) du capteur et constitue une impédance de valeur ohmique supérieure à celle de la charge, et dont la sortie (S) est reliée à la charge (R50). Le dispositif comprend en outre une boucle de contre-réaction comportant un transistor (T11) à effet de champ monté en drain commu, dont la grille (G11) est reliée à une borne (BA) du capteur, et dont la source (S11) est reliée à l'autre borne (BK) du capteur à travers une capacité (CBO) de valeur choisie. Le facteur de bruit d'une liaison optique utilisant ledit capteur est réduit, tout en conservant un gain élevé et plat dans une très large bande de fréquences allant de quelques kHz à quelques GHz, tandis que la boucle de contre-réaction est propre à compenser les effets indésirables de la capacité parasite (CPA) du capteur.

## Description

La présente invention concerne un dispositif d'interface entre un capteur optoélectronique hyperfréquence à large bande et une charge.

Elle s'applique en particulier à la fabrication de circuits intégrés monolithiques hyperfréquences, destinés en particulier à la transmission de signaux hyperfréquences à très large bande sur fibre optique.

D'une façon générale, les capteurs optoélectroniques tels que les photodiodes, se comportent comme une source de courant commandée par la modulation de la lumière incidente dans laquelle une capacité parasite C se trouve montée en parallèle sur une résistance de très forte valeur.

Du point de vue de l'adaptation d'impédance, la charge idéale (appelée encore résistance de lecture) à présenter à cette photodiode serait une résistance R de forte valeur. La fréquence de coupure étant proportionnelle à la constante de temps RC, il en résulte qu'une telle charge, associée à la capacité parasite C, pourrait engendrer, selon la photodiode utilisée, une fréquence de coupure bien inférieure à la fréquence maximale d'utilisation des liaisons optiques hyperfréquences.

Un moyen de réduire la valeur de la constante de temps RC consiste à diminuer la résistance R de la charge. Par exemple, il est connu d'abaisser cette résistance à une valeur inférieure à 50 ohms en reliant la photodiode à un amplificateur de basse impédance d'entrée. Toutefois, une telle solution a l'inconvénient de diminuer fortement le gain d'une chaîne de liaison optique, et dans certains cas d'augmenter le facteur de bruit puisque ledit facteur de bruit est une fonction décroissante de la résistance R, l'augmentation du facteur de bruit étant d'autant plus sensible que la puissance incidente sur la photodiode est faible.

Par ailleurs, dans EP-A-801466, la Demanderesse a proposé un montage appelé "boucle de contre-réaction" ou "bootstrap", dans lequel les effets négatifs de la capacité parasite de la photodiode sont compensés en annulant la différence de potentiel aux bornes de ladite capacité parasite. En pratique, cette boucle de contre-réaction comprend un transistor à effet de champ, monté en drain commun, dont la grille est reliée à une borne du capteur, et dont la source est reliée à l'autre borne du capteur.

En outre, la boucle de contre-réaction est complétée par un étage d'adaptation d'impédance comprenant un autre transistor monté en drain commun. La grille du transistor de l'étage d'adaptation est connectée à la source du transistor de la boucle de contre-réaction et la source du transistor de l'étage d'adaptation est appliquée à la charge d'impédance normalisée 50 ohms.

Un tel étage d'adaptation d'impédance n'est pas totalement satisfaisant dans la mesure où la récupération du signal utile est réalisée ici sur la résistance de source du transistor de la boucle de contre-réaction. De plus, une capacité de liaison est intercalée entre la source du transistor de la boucle de contre-réaction et la grille du transistor d'adaptation d'impédance, et une inductance de choc est directement placée en parallèle sur la charge.

Il en résulte, entre autres inconvénients, une limitation de la récupération du signal utile vers les basses fréquences.

La présente invention apporte une solution à ce problème.

Elle porte sur un dispositif d'interface entre un capteur optoélectronique hyperfréquence à large bande et une charge dont l'impédance est inférieure à celle du capteur, ledit dispositif d'interface comprenant un étage d'adaptation d'impédance.

Selon une définition générale de l'invention, l'étage d'adaptation comprend un amplificateur distribué à large bande de fréquences, dont l'entrée est directement reliée à une borne du capteur et constitue une impédance de valeur ohmique supérieure à celle de la charge, et dont la sortie est reliée à la charge, le dispositif d'interface comprenant en outre une boucle de contre-réaction comportant un transistor à effet de champ monté en drain commun, dont la grille est reliée à une borne du capteur et dont la source est reliée à l'autre borne du capteur à travers une capacité de valeur choisie.

La haute impédance d'entrée de l'amplificateur distribué selon l'invention permet de réduire le facteur de bruit d'une chaîne de liaison optique comportant un tel dispositif d'interface tout en conservant un gain élevé et plat dans une très large bande de fréquences allant de quelques kHz à quelques GHz, tandis que la boucle de contre-réaction selon l'invention est propre à compenser les effets indérisables de la capacité parasite du capteur vers les hautes fréquences sans incidences néfastes en basses fréquences.

En pratique, l'amplificateur distribué comprend une pluralité de cellules amplificatrices montées chacune entre une ligne de grille et une ligne de drain, chaque cellule comportant un circuit actif possédant au moins un transistor à effet de champ monté en source commune, et des éléments passifs constituant des tronçons de la ligne de grille et de la ligne de drain, l'une des extrémités de la ligne de grille étant reliée directement à l'une des bornes du capteur, et l'une des extrémités de la ligne de drain étant reliée à la charge.

De préférence, la polarisation de l'amplificateur distribué selon l'invention est à charges saturables, ce qui permet d'éviter les limitations vers les basses fréquences.

D'autres caractéristiques et avantages de l'invention apparaîtront à la lumière de la description détaillée ci-après et des dessins dans lesquels :
- la figure 1 est un schéma de principe du dispositif d'interface entre un capteur optoélectronique hyperfréquence à large bande de fréquences et une charge dont l'impédance est inférieure à celle du capteur selon l'invention ; et
- la figure 2 est un schéma détaillé de l'amplificateur distribué assurant l'adaptation d'impédance selon l'invention.

Les dessins annexés comportent pour l'essentiel des éléments de caractère certain. Ils pourront donc non seulement servir à mieux faire comprendre la description détaillée ci-après, mais aussi contribuer à la définition de l'invention, le cas échéant.

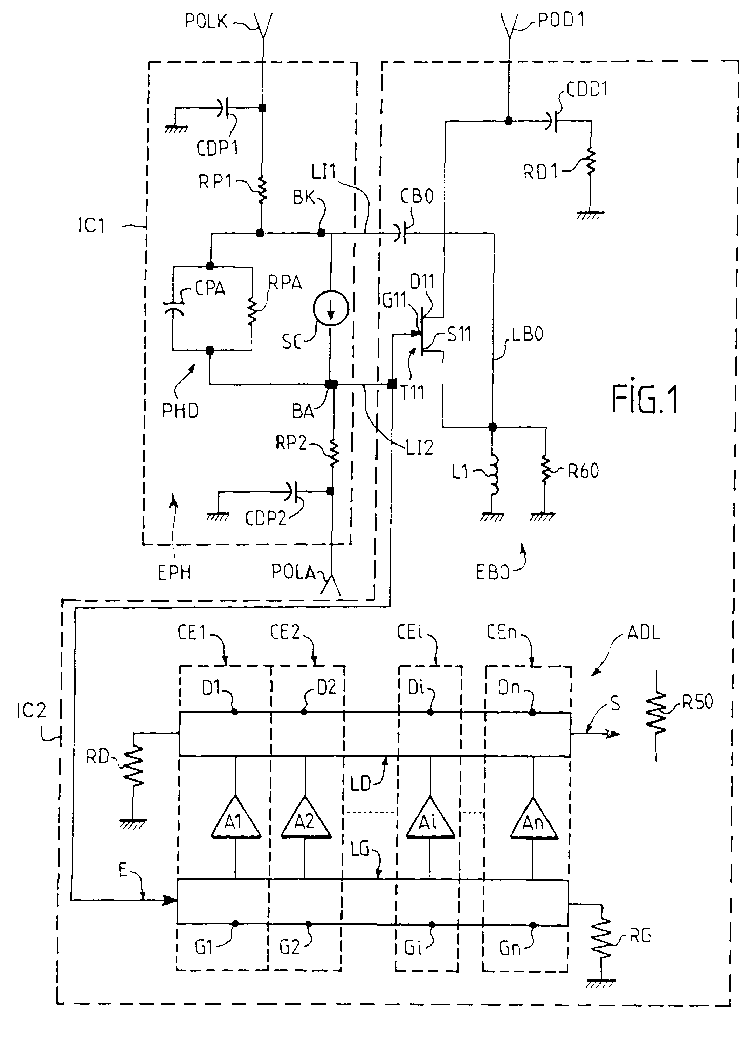

Sur la figure 1, le schéma équivalent d'une photodiode PHD correspond à une source de courant SC comportant des bornes BK et BA entre lesquelles une capacité parasite CPA et une très haute impédance RPA sont montées en parallèle.

Par exemple, selon le prix des photodiodes, la capacité parasite CPA varie d'une valeur relativement élevée de l'ordre 0,7 pF à une valeur relativement faible de l'ordre de 0,05 pF. L'impédance RPA est supérieure à 2000 ohms.

Une tension de polarisation continue POLK est appliquée à la borne (cathode) BK de la source de courant SC à travers une résistance de polarisation RP1, montée en série. Une capacité CDP1 est prévue pour découpler le signal hyperfréquence. L'une des armatures de la capacité de découplage CDP1 est mise à la masse tandis que l'autre armature est reliée à une borne de la résistance RP1.

De même, une tension de polarisation continue POLA est appliquée à la borne (anode) BA de la source de courant SC à travers une résistance de polarisation RP2. Une capacité CDP2 est également prévue pour découpler le signal hyperfréquence. L'une des armatures de la capacité CDP2 est reliée à l'une des bornes de la résistance RP2 tandis que l'autre armature de la capacité CDP2 est appliquée à la masse.

La Demanderesse s'est posée le problème de fournir un dispositif d'interface, entre l'étage photodiode EPH et une charge d'impédance inférieure à celle de la photodiode, comprenant un étage d'adaptation d'impédance capable de réduire le facteur de bruit d'une liaison optique comportant un tel étage photodiode.

La solution proposée selon l'invention consiste à équiper l'étage d'adaptation d'impédance d'un amplificateur distribué à large bande de fréquences ADL à haute impédance d'entrée et dont l'entrée est reliée directement à une borne BA du capteur. L'entrée de cet amplificateur distribué constitue alors la charge utile de la photodiode, aussi appelée "impédance de lecture".

On entend ici par "relié directement" le fait qu'il n'y a pas de capacité de liaison entre l'étage de photodiode et l'étage d'adaptation d'impédance.

En effet, la Demanderesse a perçu la possibilité de supprimer la capacité de liaison entre l'étage photodiode et l'étage d'adaptation car la tension continue nécessaire pour la polarisation de l'amplificateur, et, le cas échéant, pour le transistor de la boucle de contre-réaction (ou bootstrap) que l'on décrira plus en détail ci-après est une tension de grille.

Par rapport à EP-A-801466, l'absence de capacité de liaison entre l'étage de photodiode et l'étage d'adaptation d'impédance permet d'élargir la bande de récupération du signal utile vers les basses fréquences.

D'une façon générale, l'amplificateur distribué ADL comprend une pluralité de cellules amplificatrices A individualisées en A1 à An montées chacune entre une ligne de grille LG et une ligne de drain LD.

Chaque cellule amplificatrice comporte un circuit actif possédant un transistor à effet de champ monté en source commune. Des éléments passifs constituent des tronçons de la ligne de grille et de la ligne de drain. La tête de la ligne de grille LG forme l'entrée E de l'amplificateur distribué. L'autre extrémité EX1 de la ligne de grille est chargée sur une résistance terminale RG qui est sensiblement égale à l'impédance caractéristique de la ligne de grille. Inversement, l'une EX2 des extrémités de la ligne de drain est chargée sur une résistance terminale RD sensiblement égale à l'impédance caractéristique de la ligne de drain, tandis que l'autre extrémité de la ligne de drain définit la sortie S de l'amplificateur distribué destinée à être reliée à la charge R50.

En pratique, le signal d'entrée de l'amplificateur distribué se propage sur la ligne de grille LG. Chaque structure amplificatrice, par exemple la structure A1, reçoit le signal d'entrée en son point G1 et fournit à la ligne de drain en son point D1 une version amplifiée du signal d'entrée, version qui se propage sur cette ligne de drain LD.

Les lignes LG et LD sont non dispersives jusqu'à leur fréquence de coupure, ce qui assure un comportement très large bande.

Avantageusement, les valeurs des éléments passifs servant à constituer les tronçons de la ligne de drain et/ou de la ligne de grille de chaque cellule sont choisies pour que l'impédance caractéristique de chaque cellule soit plus petite que celle de la cellule précédente, selon le sens de propagation des signaux hyperfréquence, et conformément à une loi choisie, afin d'amener progressivement l'impédance caractéristique de la ligne de drain à une valeur choisie permettant une adaptation haute impédance entre la photodiode et la charge, tout en conservant un gain plat et sans discontinuités sur la très large bande de fréquence allant de quelques kHz à quelques GHz.

Une telle structure a l'avantage de fournir une adaptation d'impédance large bande de manière simple, et facile à mettre en oeuvre sans engendrer de perte de puissance.

De plus, l'amplificateur distribué hyperfréquence à haute impédance d'entrée, décrit en référence à la figure 1, non seulement est utilisé pour assurer les fonctions d'amplification, mais aussi pour exercer une fonction d'adaptation d'impédance permettant d'obtenir un gain plat, élevé, et sans discontinuité sur une très large bande de fréquence.

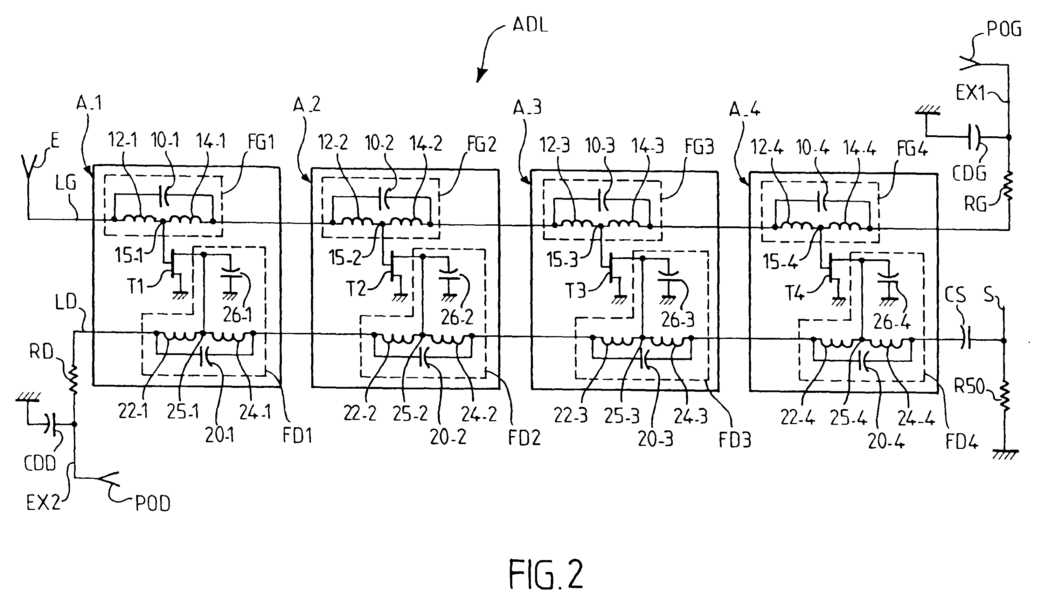

En référence à la figure 2, une tension de polarisation POG est appliquée à l'extrémité EX1 de la ligne de grille LG à travers la résistance terminale RG d'une valeur ohmique qui représente l'impédance caractéristique de la ligne de grille LG, par exemple de l'ordre de 125 ohms. Cette tension peut éventuellement être utilisée pour polariser la grille du transistor T11 à la place de la tension POLA décrite en référence à la figure 1. Dans ce cas, les composants RP2 et CDP2 sont supprimés.

Une tension de polarisation POD est appliquée à l'extrémité EX2 de la ligne de drain LD à travers la résistance terminale RD d'une valeur ohmique de l'ordre de 50 ohms par exemple.

Une capacité de découplage CDG, reliée à la masse, est montée en parallèle entre la résistance terminale RG et les circuits de polarisation délivrant la tension POG.

De même, une capacité de découplage CDD reliée à la masse est montée en parallèle entre la résistance terminale RD et les circuits de polarisation délivrant la tension POD.

Les éléments passifs servant à constituer les tronçons de la ligne de grille FG, par exemple FG1 de chaque cellule, par exemple la cellule A1 comprennent deux inductances en série 12-1, 14-1 et une capacité 10-1 montée en parallèle sur ces deux inductances 12-1 et 14-1. Les deux inductances peuvent comprendre une mutuelle inductance. Avec la capacité grille/source du transistor, une telle structure est, d'une façon générale, un filtre de type passe-tout qui peut être transformé en passe-bas s'il n'y a pas de contrainte particulière telle qu'une puissance de sortie.

Dans la mesure où la capacité 10-1 a une valeur très faible, elle n'est pas réalisée matériellement. Elle est répartie dans les inductances 12-1 et 14-1. Le point commun 15-1 des deux inductances 12-1 et 14-1 est par conséquent relié à la grille du transistor T1. La valeur de la mutuelle inductance est ici avantageusement nulle. Les éléments passifs FG ainsi agencés constituent alors simplement un filtre de type passe-bas.

Les éléments passifs servant à constituer les tronçons de ligne de drain FD (par exemple FD1) de chaque cellule, (par exemple la cellule A1) comprennent deux inductances en série 22-1 et 24-1 et une capacité 20-1 montée en parallèle sur ces deux inductances 22-1 et 24-1. Les deux inductances peuvent comprendre une mutuelle inductance. Avec la capacité drain/source du transistor, une telle structure est un filtre de type passe-tout.

La capacité 20-1 étant de faible valeur, elle est répartie dans les inductances 22-1 et 24-1. Le point commun 25-1 des deux inductances 22-1 et 24-1 est par conséquent relié au drain du transistor T1. La valeur de la mutuelle inductance est ici avantageusement nulle. Entre le point commun 25-1 du drain et de la masse, est montée une capacité 26-1 que l'on décrira plus en détail ci-après. Les éléments passifs FD ainsi agencés constituent alors simplement un filtre de type passe-bas.

Avantageusement, en modifiant les valeurs des éléments passifs FD et/ou FG d'une cellule par rapport à celle de la cellule suivante, et en choisissant ces valeurs selon une loi choisie que l'on décrira plus en détail ci-après, une adaptation d'impédance est obtenue entre la photodiode et la charge, tout en conservant une platitude de gain sur toute la largeur de bande hyperfréquence.

Selon un premier mode de réalisation décrit en référence à la figure 2, seules les valeurs des éléments passifs FD de chaque cellule sont différentes d'une cellule à l'autre tandis que les valeurs des éléments passifs FG sont constantes d'une cellule à l'autre.

Dans un second mode de réalisation (non représenté) les valeurs des éléments passifs FG varient aussi d'une cellule à l'autre.

Il est nécessaire que les signaux qui se propagent selon les deux lignes LG et LD se recombinent en phase à chaque cellule. Par exemple, l'impédance d'entrée de l'amplificateur distribué est égale à 125 ohms tandis que l'impédance de la charge sur laquelle est appliquée la sortie de l'amplificateur distribué est de 50 ohms. Ainsi, pour que les deux lignes LG et LD soient adaptées en impédance, il faut que le rapport LGG/CGS soit sensiblement égal au carré de 125 ohms tandis que le rapport LDD/CD soit sensiblement égal au carré de 50 ohms avec LGG = somme des inductances 12 et 14, CGS = capacité grille/source du transistor, LDD = somme des inductances 22 et 24, et CD = somme des capacités drain/source du transistor et de la capacité 26.

Pour chaque cellule, l'égalisation des vitesses de phase impose en première approximation que les produits LGG.GCS et LDD.CD soient sensiblement égaux.

Dans la pratique, les transistors à effet de champ possèdent une capacité grille/source bien supérieure à leur capacité drain/source. Par exemple, les transistors à effet de champ utilisés dans l'amplificateur distribué décrit en référence à la figure 2 sont du type GaAs.

En pratique, le transistor possède une capacité grille/source d'environ 82 fF et une capacité drain/source d'environ 27 fF.

Pour satisfaire les deux conditions précitées, on choisit alors de faire varier la valeur de la capacité 26 d'une cellule à l'autre de façon croissante vers la sortie de l'amplificateur.

La Demanderesse a obtenu une adaptation d'impédance 125 ohms/50 ohms avec un amplificateur distribué de quatre cellules, dont les éléments constitutifs présentent les valeurs suivantes compte-tenu des nombreux parasites inhérents aux composants (bien évidemment, d'autres configurations avec d'autres valeurs peuvent aussi convenir selon l'invention) :
- tension de polarisation drain POD = + 5V
- tension de polarisation grille POG = - 0,3V
- inductances 12-1 à 12-4 et 14-1 à 14-4 respectivement égales à 0,48 nH; 0,36 nH, 0,24 nH; 0,12 nH

- capacités 10-1 à 10-4 = 10,3 fF
- inductances 22-1 et 24-1 = 0,55 nH
- capacité 20-1 = 27 fF
- capacité 26-1 = 70 fF

L'homme de l'art remarquera que pour cette première cellule A1 les deux équations précitées sont sensiblement vérifiées (susceptibles de varier en fonction des parasites).

En ce qui concerne la cellule A2 les valeurs des éléments de filtrage drain sont les suivantes :
- inductances 22-2 et 24-2 = 0,33 nH
- capacité 20-2 = 33 fF
- capacité 26-2 = 94 fF

En ce qui concerne la cellule A3 les valeurs des éléments de filtrage drain sont les suivantes :
- inductances 22-3 et 24-3 = 0,22 nH
- capacité 20-3 = 33 fF
- capacité 26-3 = 94 fF

Enfin, pour la cellule A4, les valeurs des éléments de filtre-drain sont les suivantes :
- inductances 22-4 et 24-4 = 0,136 nH
- capacité 20-4 = 27 fF
- capacité 26-4 = 70 fF

L'homme du métier remarquera que les équations précitées sont sensiblement vérifiées pour chacune des cellules A1 à A4.

De plus, il observera que l'impédance caractéristique de la ligne de drain de chaque cellule diminue par rapport à celle de la cellule précédente selon la loi suivante :
- ZDr = Zcd (nce/r)^{x} avec
- nce nombre de cellules (ici nce = 4), et
- r = rang de la cellule

ZDr impédance caractéristique de la ligne de drain de la cellule CE de rang r,
Zcd impédance de la charge de sortie (ici = 50 ohms),
x réel, 0 < x < 1,

Par exemple avec x = 0,5 l'impédance caractéristique de la ligne de drain de la cellule A1 est égale à 100 Ω et l'impédance caractéristique de ligne de drain de la cellule A4 est égale à 50 Ω

La progression des impédances de ligne de grille des cellules peut aussi vérifier la formule suivante :
ZGr = Zgd ((nce-r)/nce)^{y} où Zgd est l'impédance d'entrée (ici de l'ordre de 125 ohms) et où y est de l'ordre de 0,5.

On remarquera que ce sont les valeurs des inductances 22 et 24 ainsi que celles de la capacité 26 qui sont réellement modifiées d'une cellule à l'autre pour obtenir l'adaptation d'impédance choisie.

A la sortie S de l'amplificateur, il convient d'éliminer la tension continue de la ligne de drain. Pour cela, on utilise par exemple un condensateur CS disposé entre l'extrémité 24-4 de la ligne de drain et la sortie S de l'amplificateur. Par exemple, le condensateur CS a une valeur capacitive la plus grosse possible, de l'ordre de quelques nF ou plus si possible.

Pour éviter d'être limité vers les basses fréquences, la polarisation de l'amplificateur distribué est à charges saturables. Ainsi, les moyens de polarisation de la ligne de drain commune comprennent une pluralité de transistors à effet de champs auxiliaires fonctionnant en charge saturable. Les sources respectives des transistors auxiliaires sont distributivement connectées sur la ligne de drain commune et les drains respectifs des transistors auxiliaires reçoivent en série la tension de polarisation POD.

Un tel amplificateur distribué à charges saturables est décrit dans le document FR-A-2 727 585 dont la description fait partie intégrante de la présente Demande à toutes fins utiles.

La Demanderesse s'est posée aussi le problème de fournir à ce dispositif d'interface des moyens capables de supprimer les effets néfastes engendrés par la capacité parasite CPA.

Selon l'invention, en référence à la figure 1, il est prévu d'appliquer à l'étage photodiode EPH, un étage EBO de type "bootstrap" ou "boucle de contre-réaction" comportant un transistor T11 monté en drain commun pour supprimer, à la fréquence de résonnance, les effets néfastes de la capacité parasite de la photodiode.

En pratique, l'étage photodiode EPH est intégré sur un composant microélectrique IC1. L'étage bootstrap EBO et l'amplificateur distribué ADL sont intégrés sur un autre composant microélectrique IC2. Les composants IC1 et IC2 sont reliés l'un à l'autre par une liaison LI1 reliant la borne BK à l'une des armatures de la capacité CBO et une liaison LI2 reliant la borne BA à la grille G11.

Jusqu'à une fréquence limite déterminée par les éléments parasites du montage, le transistor T11 se comporte comme un amplificateur à gain unité ramenant à l'entrée de la source de courant la même tension en phase et en module qu'à sa sortie, ce qui permet d'appliquer au circuit formé par la capacité CPA et la résistance RPA une tension sensiblement nulle. Au delà de cette fréquence limite, des phénomènes plus complexes apparaissent, liés à des résonnances entre notamment, la capacité parasite de la photodiode et les inductances équivalentes aux éléments de câblage et de connexion (par exemple, les liaisons LI1 et LI2). Le montage peut encore fonctionner mais plus on s'éloigne de la fréquence limite, plus le fonctionnement pratique devient problématique.

A titre d'exemple, si on considère une photodiode de large surface réceptrice (diamètre de 160 µm) dont la capacité parasite est supérieur à 1pf, la fréquence limite se situe aux alentours de 6 GHz, alors que la fréquence de coupure, en connectant directement la photodiode sur 50 Ω, se situe aux alentours de 2GHz. Pour des photodiodes de très faible capacité parasite (<0,1 pF), le montage bootstrap perd de son intérêt, tout au moins en utilisant la technique actuelle des fils de liaison (LI1 et LI2)

En pratique, la source Sll du transistor T11 est reliée à la borne BK de la source de courant SC à travers un circuit comprenant une ligne LBO et une capacité CBO.

L'étage EBO est complété par un circuit de polarisation propre à délivrer une tension de polarisation pour le drain du transistor T11. Cette tension de polarisation POD1 est appliquée directement au drain D11 du transistor T11. Très avantageusement, pour éviter que le transistor T11 oscille spontanément, il est prévu une résistance de stabilité RD1 dont une borne est reliée à la masse et dont l'autre borne est reliée au circuit de polarisation qui délivre la tension POD1. Une capacité de découplage CDD1 est intercalée entre le drain D11 et la résistance RD1.

La grille G11 du transistor T11 est reliée à la borne BA de la source de courant SC. Le cas échéant, le circuit de polarisation de la grille applique la tension continue de polarisation POG1 à travers la résistance RP2.

Par exemple, la valeur élémentaire des capacités CDP1, CDP2, CDD1 est de 5 pF en interne sur la puce et de quelques µF en externe.

Les valeurs ohmiques des résistances RP1 et RP2 sont de 100 Ω.

La valeur ohmique de la résistance de stabilité RD1 est par exemple de 5 Ω.

L'étage EBO est complété par une inductance L1 ayant une borne mise à la masse et une autre borne reliée à la source S11 du transistor T11. La valeur de l'inductance L1 est de l'ordre de 4 nH. Une résistance R60 de l'ordre de 60 Ω par exemple, est placée en parallèle sur l'inductance L1, avec une borne à la masse et une autre borne reliée à la source S11.

La Demanderesse a observé que des liaisons LI1, LI2 d'une longueur de l'ordre de quelques 200 à 400 micromètres présentent des propriétés inductives déterminantes sur les phénomènes de résonances qui limitent la fréquence de validité du montage. Le remplacement des fils de liaison LI1 et LI2 par une connexion directe (de type "Flip chip" ou analogue) permettrait de repousser les limites, même pour des photodiodes à faible capacité parasite.

Par ailleurs, la capacité CBO assure ici avantageusement le découplage du signal continu servant à la polarisation de la photodiode du signal hyperfréquence à traiter. La capacité CBO a une valeur d'environ 2 pF.

Par rapport à une liaison optique complète du commerce comportant une résistance de 45 ohms en entrée d'une diode émettrice et une résistance de 50 ohms en parallèle sur la sortie d'une photodiode réceptrice, la Demanderesse a obtenu avec un émetteur équipé d'un adaptateur basse impédance tel que décrit dans le document FR-A-2747523 et un récepteur équipé d'un dispositif d'interface selon l'invention, sur une bande allant de quelques KHz (par exemple 100 KHz) à quelques GHz (par exemple 20 GHz), un gain de + 6 dB au lieu de - 35 dB pour la liaison du commerce et un facteur de bruit de 10 dB au lieu de 40 dB pour la liaison du commerce.

## Revendications

1. Dispositif d'interface entre un capteur optoélectronique (PHD) et une charge (R50) dont l'impédance est inférieure à celle du capteur, ledit dispositif d'interface comprenant un étage d'adaptation d'impédance, caractérisé en ce que l'étage d'adaptation comprend un amplificateur distribué large bande en fréquences (ADL), dont l'entrée (E) est directement reliée à une borne (BA) du capteur et constitue une impédance de valeur ohmique supérieure à celle de la charge, et dont la sortie (S) est reliée à la charge (R50), et en ce que le dispositif d'interface comprend en outre une boucle de contre-réaction comportant un transistor (T11) à effet de champ monté en drain commu, dont la grille (G11) est reliée à une borne (BA) du capteur, et dont la source (S11) est reliée à l'autre borne (BK) du capteur à travers une capacité (CBO) de valeur choisie, ce qui permet de réduire le facteur de bruit d'une liaison optique utilisant ledit capteur, tout en conservant un gain élevé et plat dans une très large bande de fréquences allant de quelques kHz à quelques GHz, tandis que la boucle de contre-réaction est propre à compenser les effets indésirables de la capacité parasite (CPA) du capteur.

2. Dispositif selon la revendication 1, caractérisé en ce que l'amplificateur distribué (ADL) comprend une pluralité de cellules (CE) amplificatrices montées chacune entre une ligne de grille (LG) et une ligne de drain (LD), chaque cellule (CE) comportant un circuit actif (A) possédant au moins un transistor à effet de champ monté en source commune, et des éléments passifs constituant des tronçons de la ligne de grille et de la ligne de drain, l'une (BA) des extrémités de la ligne de grille étant reliée directement à l'une des bornes du capteur, et l'une des extrémités de la ligne de drain (LD) étant reliée à la charge (R50).

3. Dispositif selon la revendication 2, caractérisé en ce que les valeurs des éléments passifs servant à constituer les tronçons de la ligne de drain (LD) et/ou de la ligne de grille (LG) sont choisies de manière appropriée pour que l'impédance caractéristique de chaque cellule (CE) soit plus petite que celle de la cellule précédente, et conformément à une loi choisie, afin d'amener progressivement l'impédance caractéristique de la ligne de drain (LD) à une valeur choisie permettant une adaptation haute impédance entre le capteur optoélectronique et la charge (R50).

4. Dispositif selon la revendication 2 ou la revendication 3, caractérisé en ce que la polarisation de l'amplificateur distribué (ADL) est à charges saturables.

5. Dispositif selon la revendication 1, caractérisé en ce que l'impédance d'entrée de l'amplificateur distribué a une valeur ohmique de l'ordre de 125 ohms.

6. Dispositif selon la revendication 1, caractérisé en ce que la charge (R50) a une valeur ohmique de 50 ohms.

7. Récepteur optoélectronique, caractérisé en ce qu'il comprend un dispositif d'interface selon l'une quelconque des précédentes revendications.
